# EUROPEAN PATENT APPLICATION

(11) **EP 0 718 896 A2**
(43) Date of publication of application: **26.06.1996**
(21) Application number: 95309317.6
(22) Date of filing: 20.12.1995
(51) Int. Cl.: H01L 31/103, H01L 31/18, H01L 31/0216

(54) **Photoelectric conversion semiconductor device**

(30) Priority: 20.12.1994 JP 317202/94; 06.04.1995 JP 81592/95
(71) Applicant: SEIKO INSTRUMENTS INC., Chiba-shi, Chiba 261 (JP)
(72) Inventor: Sato, Keiji, c/o Seiko Instruments Inc., Chiba-shi, Chiba (JP); Akamine, Tadao, c/o Seiko Instruments Inc., Chiba-shi, Chiba (JP); Kojima, Sadao, c/o Seiko Instruments Inc., Chiba-shi, Chiba (JP); Saito, Yutaka, c/o Seiko Instruments Inc., Chiba-shi, Chiba (JP)
(74) Representative: Sturt, Clifford Mark

(57) **Abstract**

Photoelectric conversion semiconductor device having very little reverse bias leakage. A P+ type impurity region (3) and a guard ring (17) formed on one surface of an N type semiconductor substrate (1) and an N+ type impurity region (4) formed on the opposite surface. On the P+ type impurity region a gate Si0₂ (5), a gate Si₃N₄ (6), an upper portion Si0₂ (7) and a gate polysilicon (8) are sequentially formed, the gate Si₃N₄, upper portion Si0₂ and gate polysilicon being formed in the same shape. A bias voltage is applied by a reverse voltage applying electrode (13) via a polysilicon resistor (9) and capacity readout is performed by a readout electrode (11).

## Description

The present invention relates to a photoelectric conversion semiconductor device and fabrication method for the same.

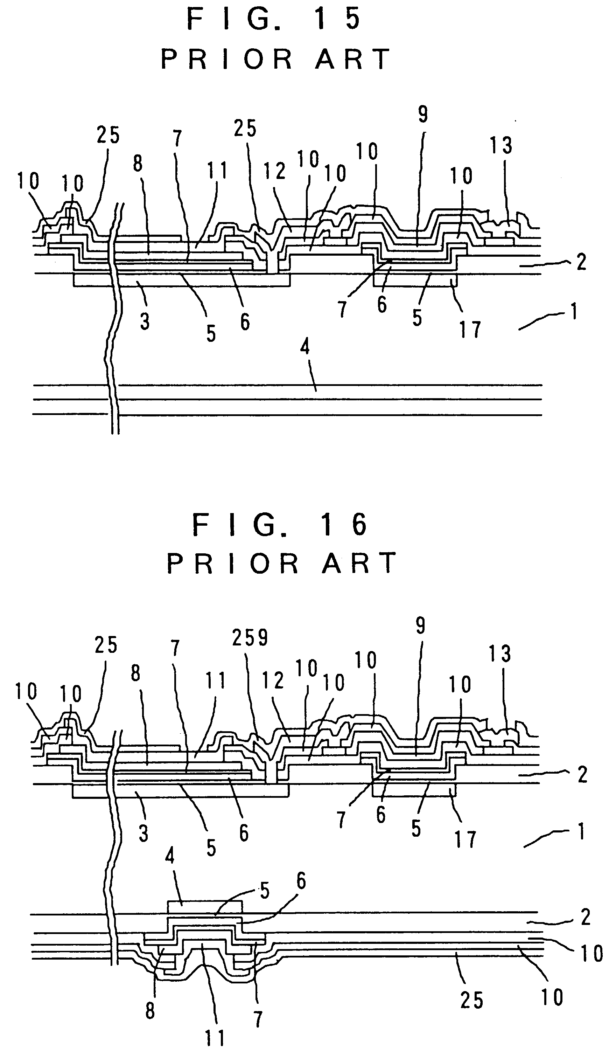

Conventionally, as a photoelectric conversion semiconductor device in this field referring to Fig. 15, a P+ type impurity region 3 and a guard ring 17 which is a P+ type impurity region for absorbing dark current from the periphery are formed in one surface of an N type semiconductor substrate 1, and an N+ type impurity region 4 whose impurity concentration is higher than the N type semiconductor substrate is formed in the other surface (referred to as the rear surface), a field SiO₂ 2 is formed in the N type semiconductor substrate 1 in portions other than those of the P+ type impurity region 3, the guard ring 17 and the N+ type impurity region 4, a gate SiO₂ 5, a gate Si₃N₄ 6, an upper portion SiO₂ 7 and a gate polysilicon 8 for example serving as a gate electrode are sequentially formed on the P+ type impurity region, the gate Si₃N₄ 6 and the upper portion SiO₂ 7 being formed adhered over an adherence portion of the gate polysilicon 8 above the field SiO₂ 2.

A readout electrode 11 is formed in the gate polysilicon 8 and a capacity readout is performed with the three layers of the gate SiO₂ 5, the gate Si₃N₄ 6 and the upper portion SiO₂ 7 as dielectrics.

In this case, although the dielectrics do not have to be three layers and a single SiO₂ or two layers of SiO₂ and Si₃N₄ are permissible, three layers of SiO₂, Si₃N₄ and SiO₂ have particularly excellent reliability and durability.

Meanwhile, a reverse voltage applying electrode 13 is connected to the P+ type impurity region 3 via a polysilicon resistor 9 which is a resistor element formed from polysilicon.

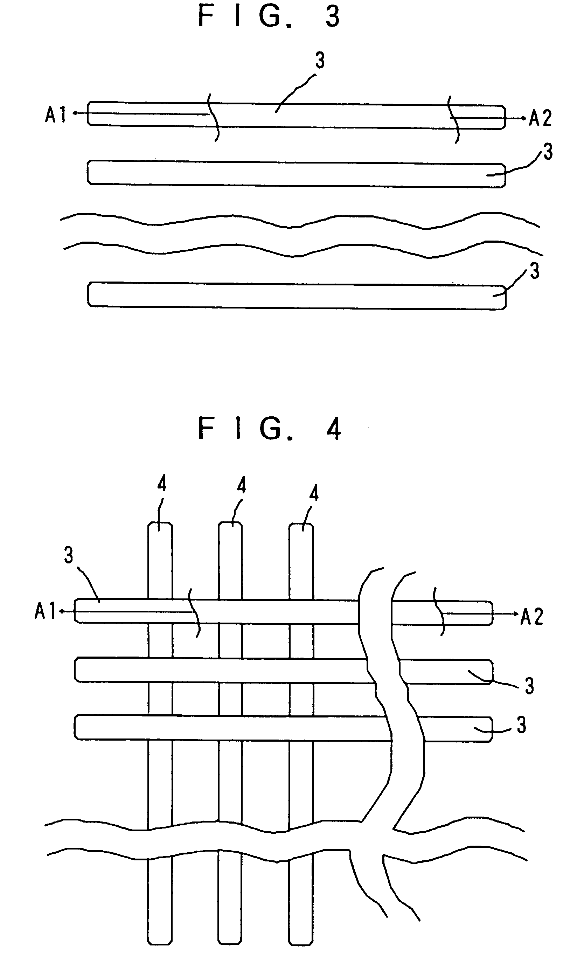

Fig. 3 is a representative plan view of the arrangement of the P+ type impurity region 3 of such a photoelectric conversion semiconductor device. Fig. 15 is a view in which a portion between the dotted lines A1 and A2 in the longitudinal direction of one strip of the P+ type impurity region 3 is omitted. This type of photoelectric conversion semiconductor device is used in detecting high energy emission beams by applying a high reverse voltage and extending a depletion layer deeply, and this photoelectric conversion semiconductor device can be made to have a two-dimensional position detection function by overlapping two thereof such that the directions of the strips are perpendicular.

In addition, as shown by the arrangement of the N+ type impurity region 4 and the P+ type impurity region 3 shown as a representative plan drawing in Fig. 4, a single photoelectric conversion semiconductor device can be made to have a two-dimensional position detection function by also making the N+ type impurity region 4 in strips in the same manner as the P+ type impurity region 3 so that it is perpendicular to the P+ type impurity region (both strips).

This photoelectric conversion semiconductor device is such that a surface of the N+ type impurity region and a surface of the P+ type impurity region have the same structure.

Fig. 16 is a view in which a portion between the dotted lines A1 and A2 in the longitudinal direction of one P+ type impurity region strip of Fig. 4 is omitted.

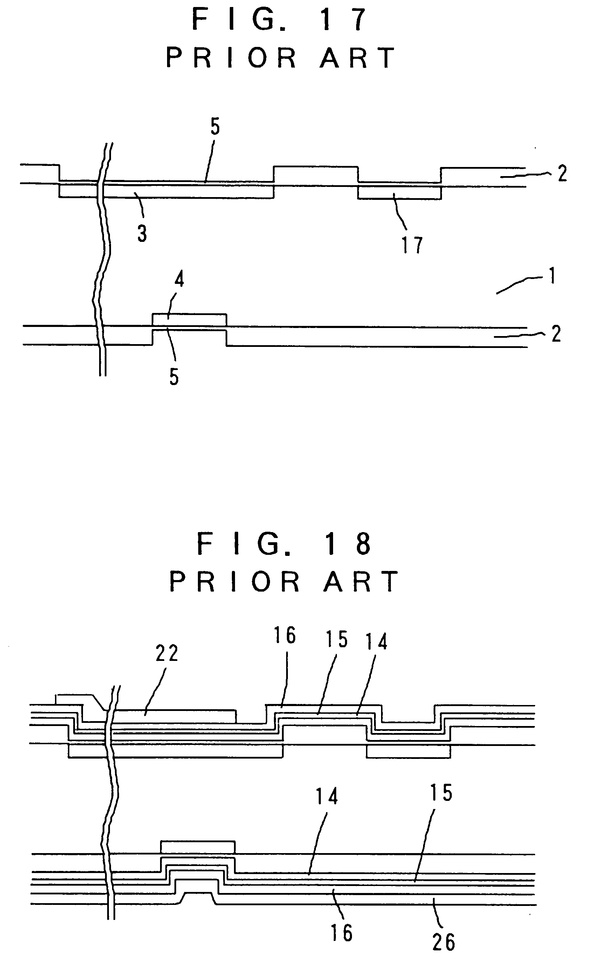

Next, process drawings of the fabrication method of the photoelectric conversion semiconductor device, in which both surfaces are formed in strips as shown in Fig. 16 and described above, are shown in Fig. 17 to Fig. 26.

The steps of the fabrication method of the photoelectric conversion semiconductor device shown in Fig. 15 are basically the same as performing the process for one side only.

In Fig. 17, a P+ type impurity region 3 and a guard ring 17 are formed in the N type semiconductor substrate 1, and an N+ type impurity region 4 whose impurity concentration is higher than the N type semiconductor substrate is formed in the rear surface thereof. A field SiO₂ 2 is formed in the N type semiconductor substrate 1 in portions other than those of the P+ type impurity region 3 and the N+ type impurity region 4, and a gate SiO₂ 5 is sequentially formed on the P+ type impurity region 3 and the N+ type impurity region 4.

Next, as shown in Fig. 18, a gate Si₃N₄ film 14, a upper portion SiO₂ film 15 and a polysilicon film 16 are sequentially formed on top of each other on both surfaces by the LPCVD method on both surfaces of the N type semiconductor substrate, and a resist 22 of the gate silicon is formed in a predetermined shape. Also, a resist 26 is coated over the entire surface of the rear surface to protect it.

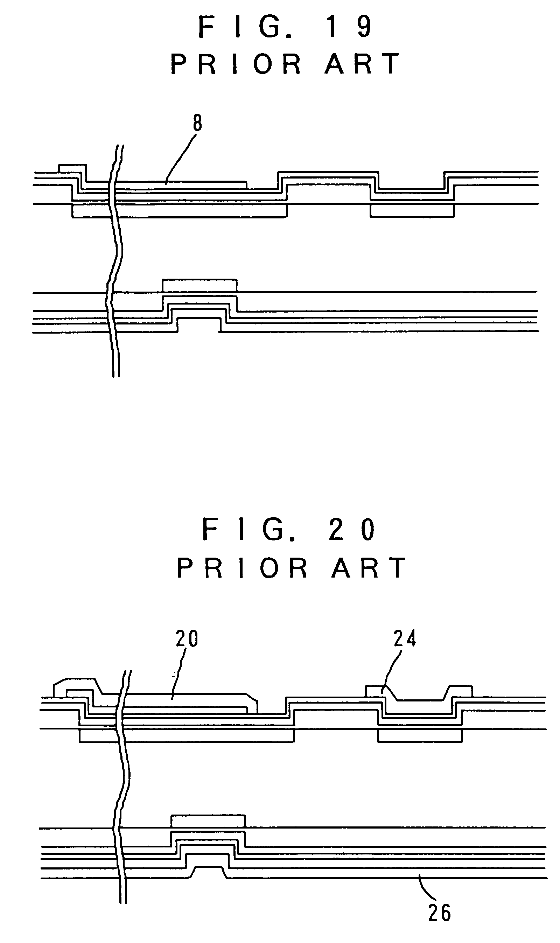

Next, as shown in Fig. 19, with the resists formed in Fig. 18 as masks, the polysilicon film 16 is etched and the gate polysilicon 8 is formed as a gate electrode in a predetermined shape.

Thereafter, as shown in Fig. 20, a resist 20 and a resist 24 are formed in the predetermined shape of the gate Si₃N₄. Also, the resist 26 is coated over the entire surface of the rear surface to protect it. Here the resist 20 must be made larger than the amount of mask alignment precision and the gate polysilicon. If this is not done there is the possibility that thereafter the gate polysilicon will be etched when the upper portion SiO₂ and the gate Si₃N₄ are etched.

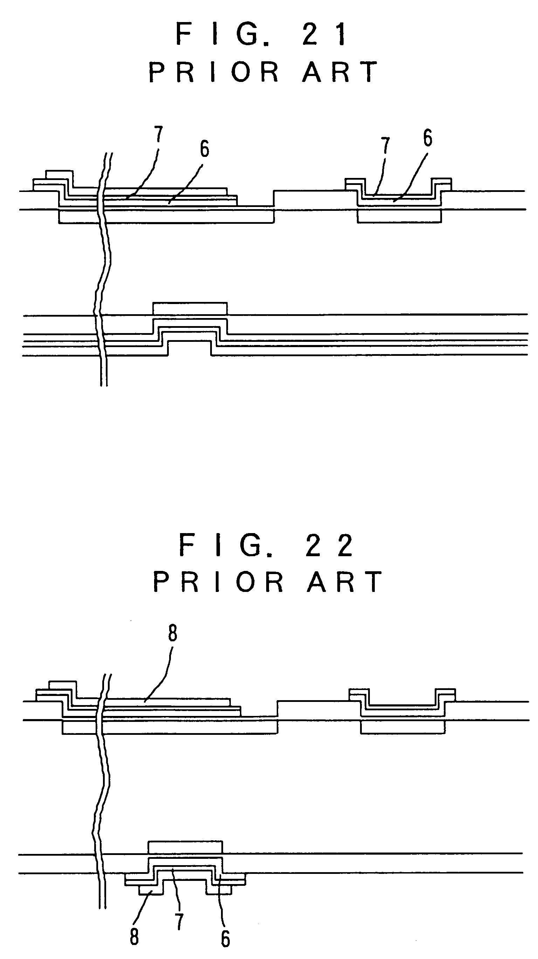

Next, as shown in Fig. 21, the upper portion SiO₂ film 15 and the gate Si₃N₄ film are etched and the upper portion SiO₂ 7 and gate Si₃N₄ 6 are formed.

By performing the same process on the surface in which the N+ type impurity region 3 is formed, the gate polysilicon 8, upper portion SiO₂ 7 and gate Si₃N₄ 6 are formed in both surfaces as shown in Fig. 22.

Thereafter, as shown in Fig. 23 an interlayer insulation film 10 is formed and next, as shown in Fig. 24, a polysilicon film 18 is formed for forming a resistor element and subsequently, as shown in Fig. 25, a resist 21 is formed in the portion which is to become the resistor element and the resist 26 for protecting the rear surface is formed thereon, while other portions are made to have low resistance by ion injection and the polysilicon resistor 9 is formed.

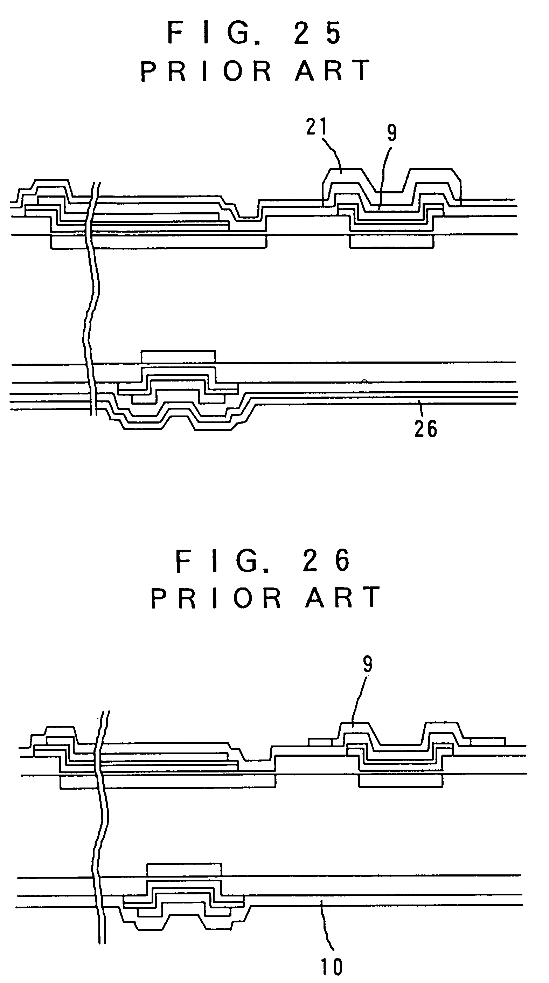

Thereafter, the polysilicon film is etched in a predetermined shape as shown in Fig. 26 and this process is also performed on the surface of the N+ type impurity region.

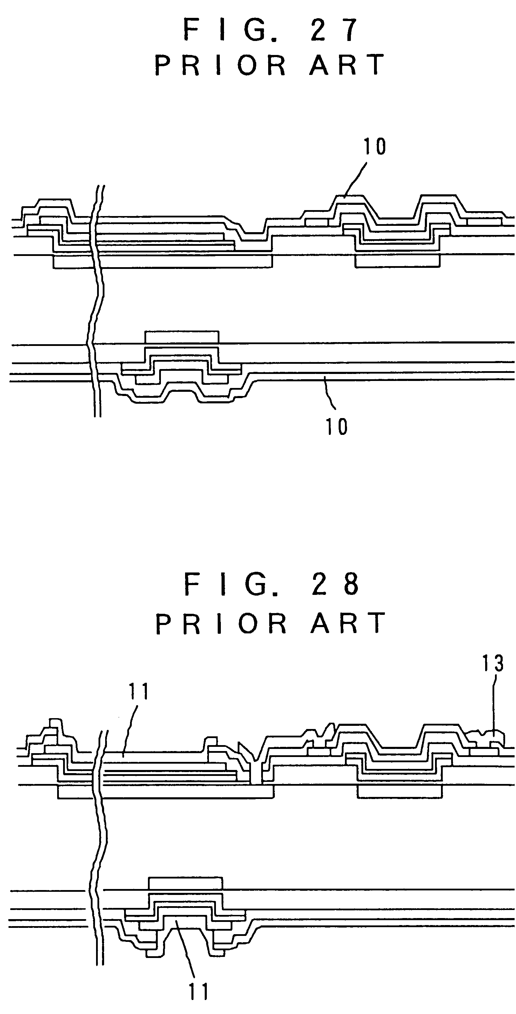

Further, as shown in Fig. 27, the photoelectric conversion semiconductor device with both surfaces formed in strips as shown in Fig. 16 is completed by forming the interlayer insulation film 10 on both surfaces and thereafter forming a contact, forming a readout line 11, reverse voltage applying electrode 13, etc. by a metal electrode of Al or the like as shown in Fig. 28 and, lastly, forming a passivation film 25.

Readout of the P+ type impurity region and N+ type impurity region in the case where both surfaces are formed as strips in this manner is performed from mutually perpendicular directions, so there are cases of deficiencies.

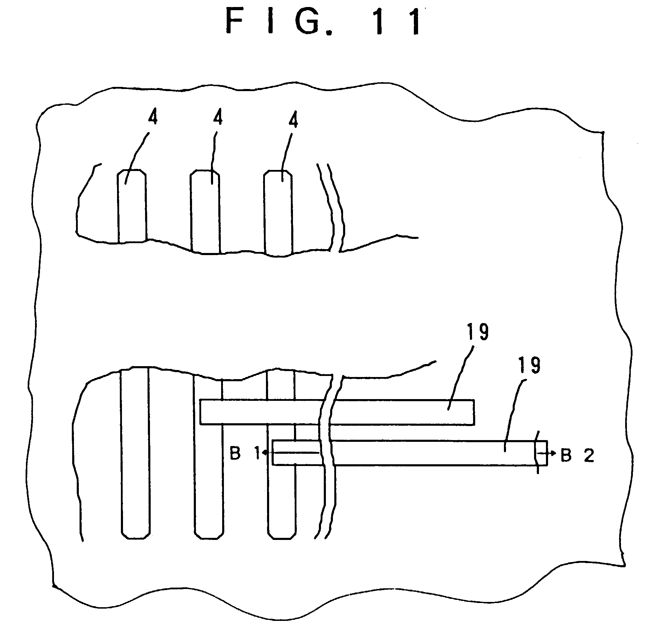

At this time a readout line 19 may be formed as a second metal electrode perpendicular to the N+ type impurity region as shown in the representative plan view of Fig. 11.

In this case it is preferred to use a polyimide film with low electrostatic capacity as the interlayer insulation film of the metal electrode etc. of the readout electrode and the second metal electrode serving as the readout line.

In the conventional photoelectric conversion semiconductor device, a photolithographic process is necessary with respect to each of the gate electrodes, for example the gate polysilicon and the gate Si₃N₄ as described above, and in addition, from the point of view of photolithographic alignment precision, the gate Si₃N₄ layer must be formed sufficiently wider than the gate electrode. Consequently, there are the problems that the number of fabrication steps increases, an Si₃N₄ film cannot but exist above the adherence portion of the gate electrode, and as a result the reverse bias leakage of the PN junction increases.

Further, where both are formed as strips, while one surface is being photolithography processed the opposite surface is in contact with a support mechanism of the device and as an effect thereof the resist, contaminants or the like are difficult to remove and cause an increase in leakage.

In a first aspect this invention provides, a photoelectric conversion semiconductor device comprising:
a first conductivity type semiconductor substrate;
a second conductivity type impurity region on a surface of the first conductivity type semiconductor substrate;
a gate SiO₂ on the second conductivity type impurity region;
a dielectric layer on the gate SiO₂, and
a gate electrode on the dielectric layer, and characterised in that the dielectric layer is formed in the same shape as the gate electrode.

In a second aspect, this invention provides a method for fabricating a photoelectric conversion semiconductor device comprising the steps of:
forming a second conductivity type impurity region on one surface of a first conductivity type semiconductor substrate;
forming a gate SiO₂, on the second conductivity impurity region;
forming a dielectric layer on the gate SiO₂; and
forming a gate electrode on the dielectric layer, characterised in that the dielectric layer and the gate electrode are both formed using the same resist as a mask.

In a third aspect, this invention provides a method for fabricating a photoelectric conversion semiconductor device comprising the steps of:
forming a second conductivity type impurity region on one surface of a first conductivity type semiconductor substrate;
forming a gate SiO₂ on the second conductivity impurity region;
forming a dielectric layer on the gate SiO₂; and
forming a gate electrode on the dielectric layer, characterised in that the dielectric layer is formed using the gate electrode as a mask.

In the methods of the second and third aspects, the dielectric layer may be formed when the gate electrode is formed.

In a fourth aspect, this invention provides a method of fabricating a photoelectric conversion semiconductor device in which a second conductivity type impurity region is formed on one surface of a first conductivity type semiconductor substrate, a first conductivity type impurity region having an impurity concentration higher than that of the substrate is formed on an opposite surface, and a gate SiO₂, a dielectric layer and a gate electrode are sequentially formed on both impurity regions, characterised by also comprising the steps of:
a resist removal step by means of a solvent, and
a resist removal step by means of oxygen plasma.

In a fifth aspect, this invention provides a method of fabricating a photoelectric conversion semiconductor device comprising the steps of:
forming a second conductivity type impurity region on one surface of a first conductivity type semiconductor substrate;
forming a gate SiO₂ on the second conductivity type impurity region;
forming a dielectric layer on the gate SiO₂;
forming a gate electrode on the dielectric layer; and
forming a reverse voltage applying electrode in the second conductivity type impurity region, and a resistor element is formed connected to the reverse voltage applying electrode, characterised in that the gate electrode and resistor element are formed from the same polysilicon film.

In a sixth aspect, this invention provides a photoelectric conversion semiconductor device comprising:
a second conductivity type impurity region on one surface of a first conductivity type semiconductor substrate;
a first conductivity type impurity region having an impurity concentration higher than the substrate formed on an opposite surface to the surface on which the second conductivity type impurity region is formed;
a first gate SiO₂ on the second conductivity type impurity region;
a second gate SiO₂ on the first conductivity type impurity region;
a first dielectric layer on the first gate SiO₂;
a second dielectric layer on the second gate SiO₂;
a first gate electrode of poly-crystalline silicon on the first dielectric layer;
a second gate electrode of poly-crystalline silicon on the second dielectric layer;
a first metal electrode on the second conductivity type impurity region;
a second metal electrode on the first conductivity type impurity region;
a polyimide inter-layer insulation film on the first metal electrode; and
a third metal electrode on the polyimide inter-layer insulation film.

In a seventh aspect, this invention provides a photoelectric conversion semiconductor device comprising:
a second conductivity type impurity region on one surface of a first conductivity type semiconductor substrate;
a first conductivity type impurity region having an impurity concentration higher than the substrate formed on an opposite surface thereof;
a first gate SiO₂ on the second conductivity type impurity region;
a second gate SiO₂ on the first conductivity type impurity region;
a first dielectric layer on the first gate SiO₂;
a second dielectric layer on the second gate SiO₂;
a first gate electrode of poly-crystalline silicon on the first dielectric layer;
a second gate electrode of poly-crystalline silicon on the second dielectric layer;
a first metal electrode on the second conductivity type impurity region;
a second metal electrode on the first conductivity type impurity region;
a polyimide inter-layer insulation film on the first metal electrode; and
a third metal electrode on the polyimide inter-layer insulation film.

In order to solve the above problems, this invention, as a first means, has a structure in which the dielectric layer on the P+ type impurity region, above the field SiO₂, does not exist above a portion which the gate electrode is adhered over.

As a second means, there is a structure in which the dielectric layer is formed by a gate Si₃N₄ and an upper portion SiO₂.

As a third means, there is a structure in which the gate SiO₂, dielectric layer and gate electrode are also formed on the N+ type impurity region and at that time the dielectric layer, above the field Si0₂, does not exist above a portion which the gate electrode is adhered over.

Next, as a fourth means, the dielectric layer is formed by etching, with the resist or the formed gate electrode when the gate polysilicon is formed on the P+ type impurity region, as a mask.

Next, as a fifth means, the gate SiO₂, dielectric layer and gate electrode are also formed on the N+ type impurity region, with the resist or the formed gate electrode when the gate polysilicon is formed on the P+ type impurity region, as a mask.

Next, as a sixth means, where both surfaces are formed as strips, in the removal of the resist by a photolithography process, there is a removal step by means of a compound solvent of sulphuric acid and hydrogen peroxide or nitric acid.

Next, as a seventh means, the resistor element connected to the reverse voltage applying electrode and the gate electrode are formed by the same polysilicon film.

As the eighth means, the polyimide interlayer insulation film is not formed in part at a portion which does not overlap the third metal electrode which is a readout electrode or the like the external connection portion (pad portion) formed by wire bonding.

Reverse bias leakage of the PN junction is reduced by the first means.

The durability of the dielectric layer is improved by the second means.

Reverse bias leakage of the PN junction is reduced by the third means.

The number of fabrication steps are reduced and the reverse bias leakage of the PN junction is reduced by the fourth and fifth means.

Reverse bias leakage leading to contamination of the rear surface resist caused by support mechanisms of the device is reduced by the sixth means.

The gate electrode, gate Si₃N₄ and upper portion SiO₂ are easily formed in the same shape and the number of fabrication steps are reduced by the seventh means.

Bonding strength is improved due to an Al electrode of the wire bonding portion being formed in the polyimide layer and a polyimide having low electrostatic capacity can be used without causing problems as the second metal electrode or the like serving as the readout line and the interlayer insulation film of the readout electrode.

A full understanding of the invention can be gained from the following description, by way of example only, of the preferred embodiment when read in conjunction with the accompanying diagrammatic figures in which:

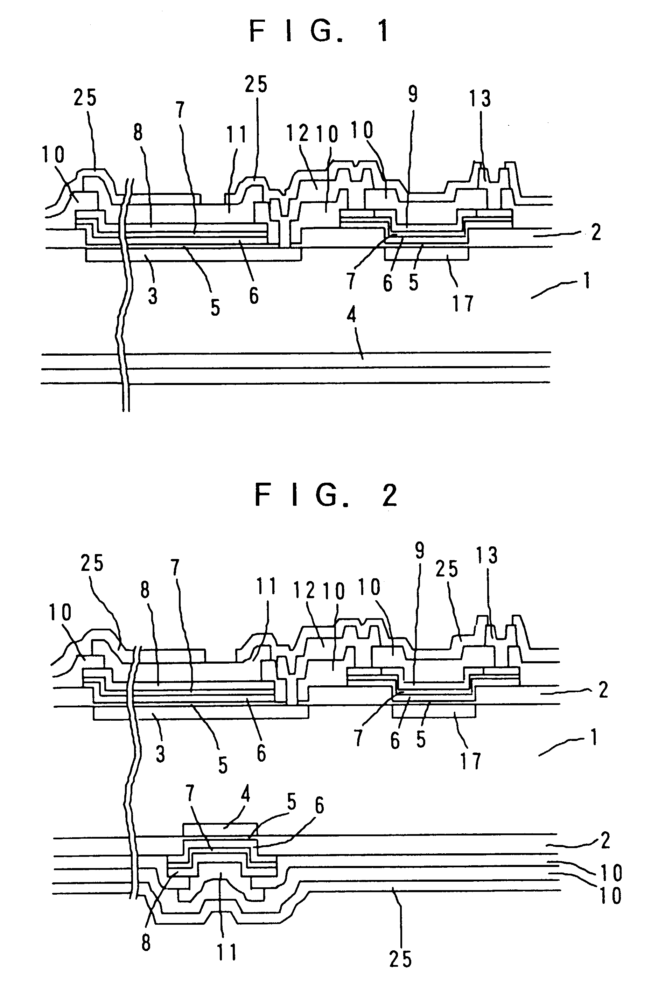

Fig. 1 is a representative cross-sectional view of a semiconductor device according to a first embodiment of the present invention;
Fig. 2 is a representative cross-sectional view of a semiconductor device according to a second embodiment of the present invention;
Fig. 3 is a representative plan view showing the wiring of a P+ type impurity region of a semiconductor device according to a first embodiment of the present invention;
Fig. 4 is a representative plan view showing the wiring of an impurity region of a semiconductor device according to a second embodiment of the present invention;

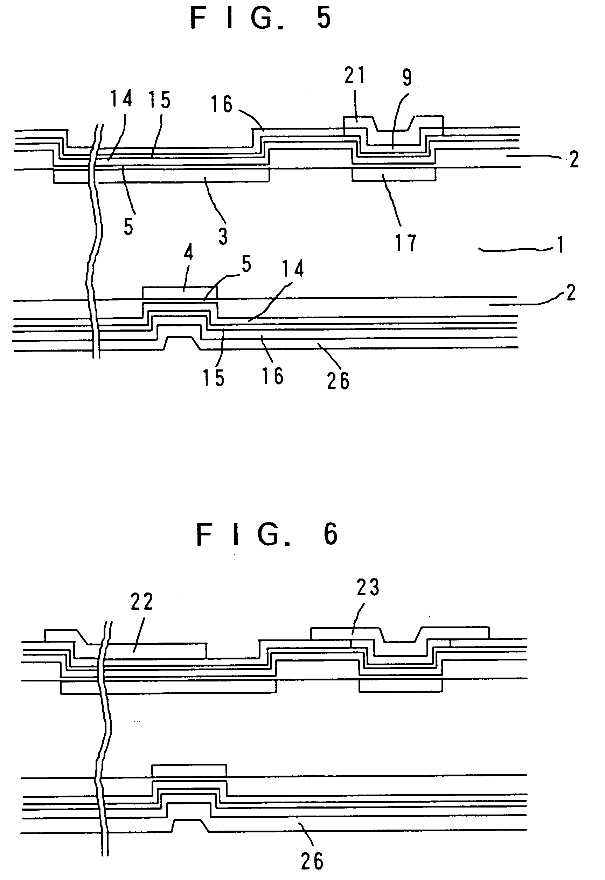

Fig. 5 is a fabrication step view of the semiconductor device of the present invention;

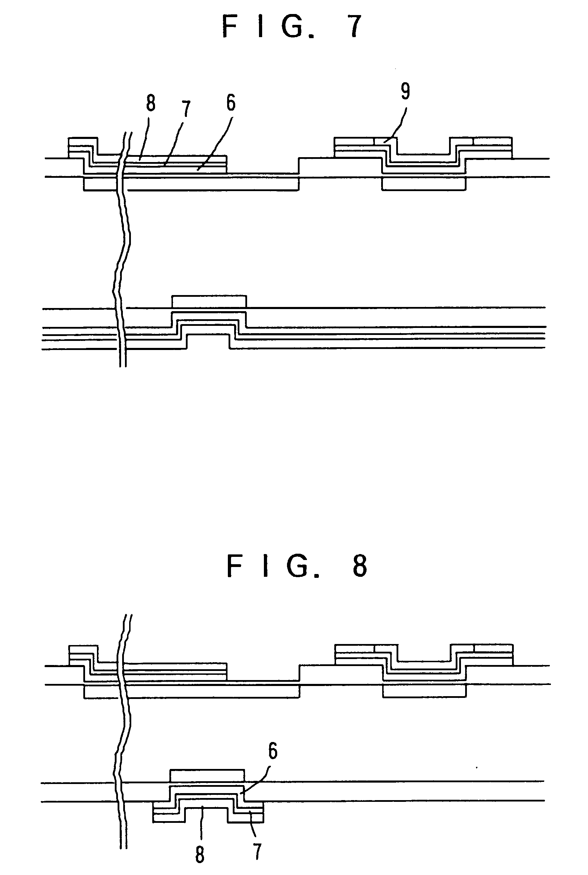

Fig. 6 is a fabrication step view of the semiconductor device of the present invention;
Fig. 7 is a fabrication step view of the semiconductor device of the present invention;
Fig. 8 is a fabrication step view of the semiconductor device of the present invention;
Fig. 9 is a fabrication step view of the semiconductor device of the present invention;

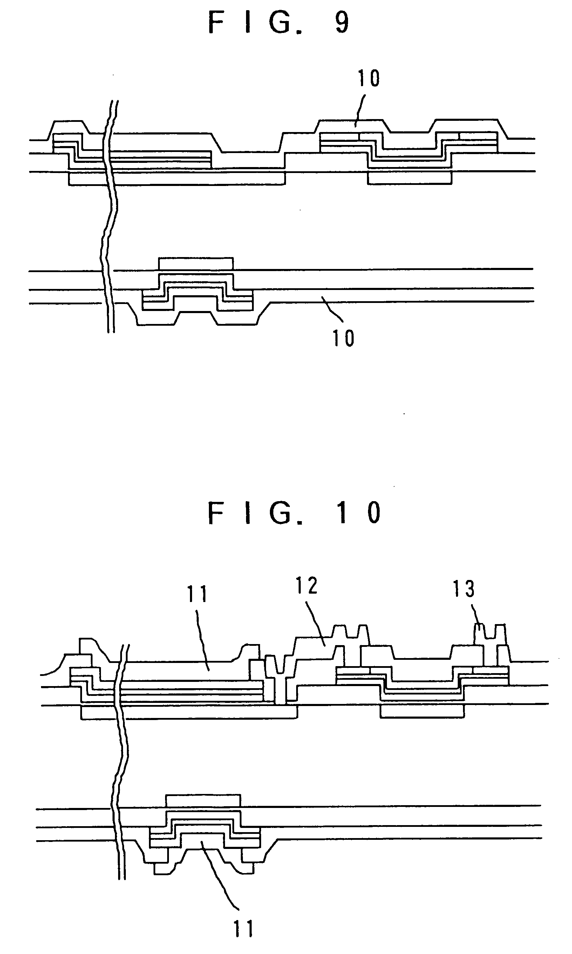

Fig. 10 is a fabrication step view of the semiconductor device of the present invention;
Fig. 11 is a representative plan view showing the wiring of a readout line of an N+ type impurity region of a semiconductor device according to a second embodiment of the present invention;

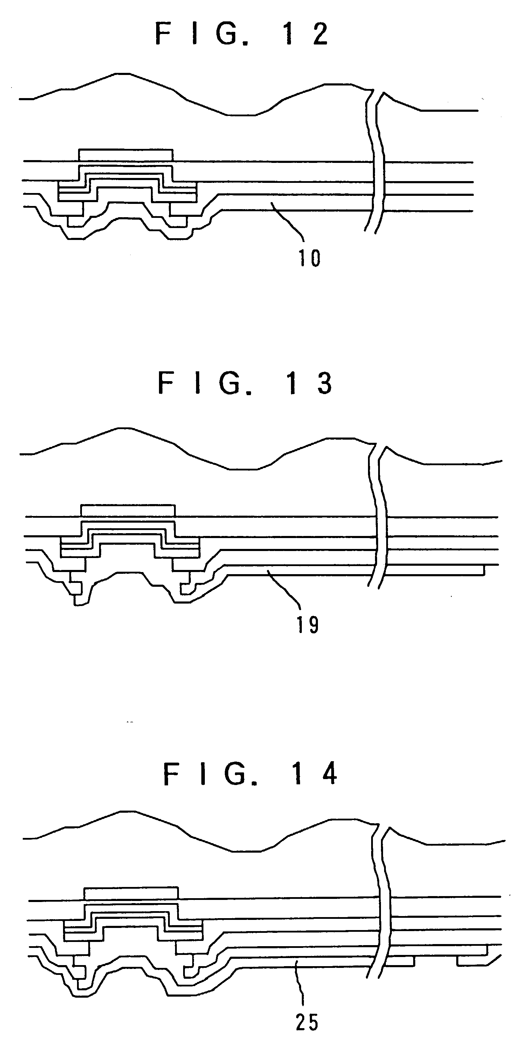

Fig. 12 is a fabrication step view of the semiconductor device of the present invention;
Fig. 13 is a fabrication step view of the semiconductor device of the present invention;
Fig. 14 is a fabrication step view of the semiconductor device of the present invention;
Fig. 15 is a representative cross-sectional view of a prior art semiconductor device;
Fig. 16 is a representative cross-sectional view of a prior art semiconductor device;
Fig. 17 is a fabrication step view of a prior art semiconductor device;
Fig. 18 is a fabrication step view of a prior art semiconductor device;
Fig. 19 is a fabrication step view of a prior art semiconductor device;
Fig. 20 is a fabrication step view of a prior art semiconductor device;
Fig. 21 is a fabrication step view of a prior art semiconductor device;
Fig. 22 is a fabrication step view of a prior art semiconductor device;

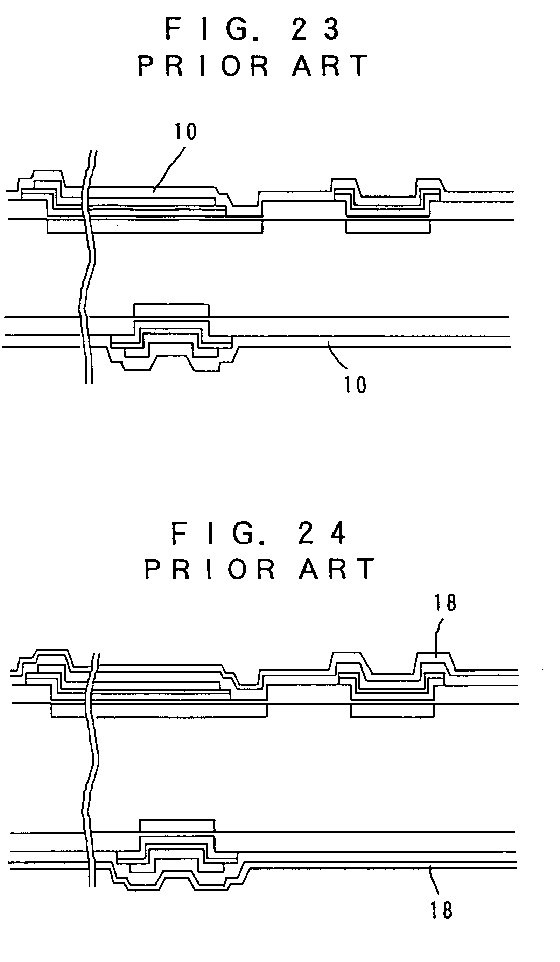

Fig. 23 is a fabrication step view of a prior art semiconductor device;
Fig. 24 is a fabrication step view of a prior art semiconductor device;
Fig. 25 is a fabrication step view of a prior art semiconductor device;
Fig. 26 is a fabrication step view of a prior art semiconductor device;
Fig. 27 is a fabrication step view of a prior art semiconductor device;
Fig. 28 is a fabrication step view of a prior art semiconductor device;

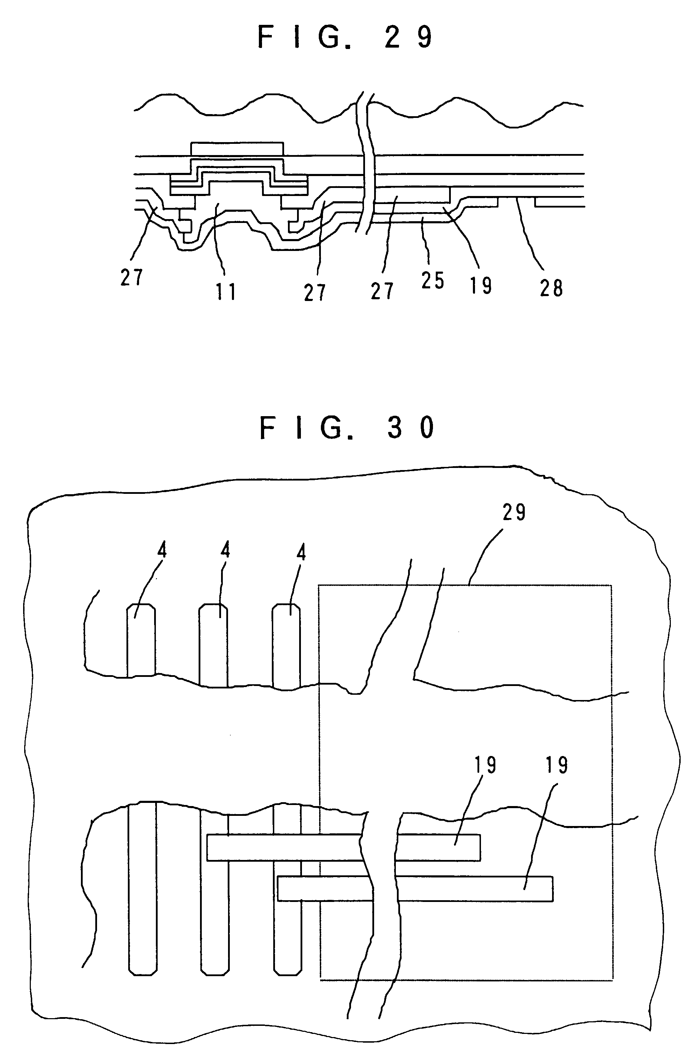

Fig. 29 is a representative cross-sectional view of a surface having an N+ type impurity region of a semiconductor device according to a third embodiment of the present invention;
Fig. 30 is a representative plan view showing the wiring of readout line an N+ type impurity region of a semiconductor device according to a third embodiment of the present invention.

Herebelow, embodiments of the present invention will be explained based on the drawings.

Fig. 1 is a representative cross-sectional drawing of a semiconductor device showing a first embodiment of the present invention, omitting one portion of a P+ type impurity region 3 of Fig. 3 between the dotted lines A1 to A2 in the longitudinal direction of one strip thereof.

The P+ type impurity region 3 and a guard ring 17 are formed in an N type semiconductor substrate 1 and an N+ type impurity region 4 whose impurity concentration is higher than the N type semiconductor substrate 1 is formed in the surface (rear surface) opposite the surface in which the P+ type impurity region 3 of the N type semiconductor substrate 1 is formed. A field SiO₂ 2 is formed in portions of the surface of the N type semiconductor substrate 1 other than where the P+ type impurity region 3, guard ring 17 and N+ type impurity region 4 are formed.

On the P+ type impurity region 3, a gate SiO₂ 5, a gate Si₃N₄ 6 as a dielectric layer, an upper portion SiO₂ 7 and a gate polysilicon 8 as a gate electrode are sequentially formed, the gate Si₃N₄ 6 and upper portion SiO₂ 7 being formed in the same shape as the gate polysilicon 8.

In this example a bias voltage is applied by a reverse voltage applying electrode 13 via a polysilicon resistor 9, and a capacity readout is performed by a readout electrode 11 by means of the capacity component between the gate polysilicon 8 and the P+ type impurity region 3.

Note that although the present invention does not necessarily have to have three dielectrics and a single SiO₂ or two layers of SiO₂ and Si₃N₄ are permissible, three layers of SiO₂, Si₃N₄ and SiO₂ have particularly excellent reliability and durability, and that although the present invention is described with respect to a three layer structure, a single layer or two layers are also suitable.

In the present invention, since the gate Si₃N₄ 6 and upper portion SiO₂ 7 are formed in the same shape as the gate polysilicon 8, the Si₃N₄ film only exists at the portions at which the gate polysilicon 8 is adhered over the field SiO₂ 2. As a result of this there is the advantage that the reverse bias leakage of the PN junction decreases.

Fig. 2 is a two-dimensional representative cross-sectional drawing of both strips of a semiconductor device of a second embodiment of the present invention in which an N+ type impurity region is also formed as a strip, omitting one portion of the P+ type impurity region 3 of Fig. 4 between the dotted lines A1 to A2 in the longitudinal direction of one strip thereof.

The gate SiO₂ 5, gate Si₃N₄ 6, upper portion SiO₂ 7 and gate polysilicon 8 as a gate electrode are sequentially formed also on the N+ type impurity region, the gate Si₃N₄ 6 and upper portion SiO₂ 7 being formed in the same shape as the gate polysilicon 8.

Fig. 5 is a step sequence cross-sectional drawing showing a second embodiment of the fabrication method of the present invention.

Note that the first embodiment of the present invention performs the same process on only one surface, and therefore will be omitted in the following explanation for ease of understanding.

The present invention is initially the same process as the prior art example, in which the P+ type impurity region 3 and guard ring 17 are formed in the N type semiconductor substrate 1 and the N+ type impurity region 4 having a higher impurity concentration than the N type semiconductor substrate 1 is formed in the rear surface thereof, as shown in Fig. 17.

The field SiO₂ 2 is formed in portions of the surface of the N type semiconductor substrate 1 other than where the P+ type impurity region 3 and N+ type impurity region 4 are formed, and the gate SiO₂ 5 is formed on the P+ type impurity region 3 and N+ type impurity region 4.

Next, in order, on both surfaces of the N type semiconductor substrate 1, a gate Si₃N₄ film 14 and thereon an upper portion SiO₂ film 15 and again thereon a polysilicon film 16 are formed by the LPCVD method, while thereafter, as shown in Fig. 5, a resist 21 of the polysilicon resistor is formed in a predetermined shape and resist 26 for protecting the rear surface is coated over the entire surface thereof.

In this way the polysilicon film 16 is given low resistance by ion injection except for the resist 21 portions, and the polysilicon resistor 9 is formed.

In the above process, it is preferable to form the gate Si₃N₄ film 14, upper portion SiO₂ film 15 and polysilicon film 16 simultaneously on both sides of the N type semiconductor substrate 1. If this is done, the number of steps is half compared to the case where they are formed on one side each time, and also, prevents deterioration as a result of scratches etc. when forming the film on one side each time due to a holder or the like which is used on the surface of the device where the film is not being formed.

Next, as shown in Fig. 6, a resist 22 and a resist 23 for forming a gate polysilicon or the like as a gate electrode and removably forming excess polysilicon from the polysilicon film 16 are formed and a resist 26 for protecting the rear surface is formed thereon.

By performing etching based on these resists and thereafter removing the resists, the predetermined gate Si₃N₄ 6, upper portion SiO₂ 7, gate polysilicon 8 and polysilicon resistor 9 are formed, at first on one surface, as shown in Fig. 7.

Note that in this case the gate Si₃N₄ 6 and upper portion SiO₂ 7 may be formed by firstly forming the gate polysilicon 8 and the polysilicon resistor 9 by etching and using the gate polysilicon 8 and polysilicon resistor 9 as masks in the process shown in Fig. 6.

By performing the same process on the remaining surface the gate Si₃N₄ 6, the upper portion SiO₂ 7, the gate polysilicon 8 and the polysilicon resistor 9 are formed on both surfaces as shown in Fig. 8.

At this stage caution is needed in removing the resists.

At the time of this double-surface process contaminants from support mechanisms etc. for the device may adhere to the resist which is formed on the rear surface to protect it and these contaminants may strongly adhere to the substrate due to the oxygen plasma process which is performed to remove the resist through ion injection and may cause a drop in the withstand pressure and a rise in reverse bias leakage which in turn cause deficiencies.

In avoiding this, performing, firstly, removal of the resist by means of a solvent such as a compound solvent of sulphuric acid and hydrogen peroxide or nitric acid etc. and then completely removing the resist by means of the oxygen plasma process is effective.

Thereafter, as shown in Fig. 9, the interlayer insulation film 10 is formed and after forming Al or the like which is formed in contact therewith, a readout electrode 11, Al electrode 12 and a reverse voltage applying electrode 13 are formed as shown in Fig. 10 by etching in a predetermined shape.

Upon such processing, there is the advantage that the process of photolithography is reduced and, since this is self-aligning, the gate Si₃N₄ 6 is formed in the same shape as the gate polysilicon 8.

If the gate polysilicon 8, upper portion SiO₂ 7 and gate Si₃N₄ 6 are each separately formed by photolithography, the mask alignment precision portion cannot but make the gate Si₃N₄ 6 larger than the gate polysilicon 8, and thus the reverse bias leakage of the junction increases.

In this state it is performed in a direction perpendicular to both the P+ type impurity region 3 and the readout of the N+ type impurity region and therefore deficiencies may occur.

At such times a readout line 19 may be formed perpendicular to the N+ type impurity region such as the arrangement of the N+ type impurity region shown representative plan view in Fig. 11.

Fig. 12 through Fig. 14 are drawings of fabrication steps at this time, omitting a portion between the dotted lines B1 and B2 in the width direction of one strip of the N+ type impurity region 4 in Fig. 11 and also omitting the surface in which the P+ type impurity region exists.

As shown in Fig. 12, continuing from Fig. 10 the interlayer insulation film 10 is formed in a surface of the N+ type impurity region and then the readout line 19 is formed perpendicular to the longitudinal direction of the N+ type impurity region by Al contacting the readout electrode 11 as shown in Fig. 13.

Next, as shown in Fig. 14, a passivation film 25 is formed.

Although if a low electrostatic capacity polyimide is used as the interlayer insulation film of the readout electrode 11 and the readout line 19 readout performance is improved, the bonding strength of Al and polyimide is weak therefore when bonding etc. it can easily peel.

As the third embodiment, there is a structure in which a polyimide non-formation portion 29 serving as the region shown by the dotted line in the representative plan view of the arrangement of the readout line of the N+ type impurity region shown in Fig. 30, or a polyimide interlayer insulation film 27 serving as an interlayer insulation film of the readout electrode 11 and the readout line 19 as shown in the representative cross-sectional view of the surface in which the N+ type impurity region exists in Fig. 29, is formed, and there is no polyimide interlayer insulation film 27 in a portion in which a pad portion 28 for wire bonding etc. exists.

In such a structure the Al electrode of the wire bonding portion has improved bonding strength since a polyimide layer is not formed and the second metal electrode or the like serving as the readout line and the polyimide with low electrostatic capacity which serves as the interlayer insulation film of the readout electrode can be used without causing any problems.

The invention provides a method for fabricating a photoelectric conversion semiconductor device comprising the steps of;
forming a second conductivity type impurity region on one surface of a first conductivity type semiconductor substrate;
forming a gate SiO₂ on the second conductivity impurity region;
forming a dielectric layer on the gate SiO₂; and
forming a gate electrode on the dielectric layer, wherein the dielectric layer is formed using a resist as a mask when the gate electrode is formed.

The invention provides a method for fabricating a photoelectric conversion semiconductor device comprising the steps of:
forming a second conductivity type impurity region on one surface of a first conductivity type semiconductor substrate;
forming a gate SiO₂ on the second conductivity impurity region;
forming a dielectric layer on the gate SiO₂; and
forming a gate electrode on the dielectric layer, wherein the dielectric layer is formed using a gate electrode as a mask when the gate electrode is formed.

As explained above, according to the method of the present invention, a photoelectric conversion semiconductor device can be obtained by a fewer number of fabrication steps which has a PN junction having very little reverse bias leakage.

The aforegoing description has been given by way of example only and it will be appreciated by a person skilled in the art that modifications can be made without departing from the scope of the present invention.

## Claims

1. A photoelectric conversion semiconductor device comprising:
a first conductivity type semiconductor substrate (1),
a second conductivity type impurity region (3) on a surface of the first conductivity type semiconductor substrate,
a gate SiO₂ (5) on the second conductivity type impurity region,
a dielectric layer (6, 7) on the gate SiO₂, and
a gate electrode (8) on the dielectric layer, and characterised in that the dielectric layer is formed in the same shape as the gate electrode.

2. A photoelectric conversion semiconductor device as claimed in claim 1, wherein the dielectric layer is a gate Si₃N₄ (6) and an upper portion SiO₂ (7) on the gate Si₃N₄.

3. A photoelectric conversion semiconductor device as claimed in claim 1 or claim 2, wherein a first conductivity type impurity region (4) having an impurity concentration higher than the impurity concentration of the substrate is formed on a surface opposite the surface on which the second conductivity type impurity region is formed, a gate SiO₂, dielectric layer and gate electrode are sequentially formed on the first conductivity type impurity region, and said dielectric layer is formed in the same shape as said gate electrode.

4. A method for fabricating a photoelectric conversion semiconductor device comprising the steps of:
forming a second conductivity type impurity region (3) on one surface of a first conductivity type semiconductor substrate (1);
forming a gate SiO₂ (5), on the second conductivity impurity region;
forming a dielectric layer (6, 7) on the gate SiO₂; and
forming a gate electrode (8) on the dielectric layer, characterised in that the dielectric layer and the gate electrode are both formed using the same resist as a mask.

5. A method for fabricating a photoelectric conversion semiconductor device comprising the steps of:
forming a second conductivity type impurity region (3) on one surface of a first conductivity type semiconductor substrate (1);
forming a gate SiO₂ (5) on the second conductivity impurity region;
forming a dielectric layer (6, 7) on the gate SiO₂; and
forming a gate electrode (8) on the dielectric layer, characterised in that the dielectric layer is formed using the gate electrode as a mask.

6. A method of fabricating a photoelectric conversion semiconductor device as claimed in claim 4 or claim 5 and further comprising the steps of:
forming a first conductivity type impurity region (4) having an impurity concentration higher than the substrate on a surface opposite the surface on which the second conductivity type impurity region is formed;
forming a gate SiO₂ (5) on the first conductivity impurity region;
forming a dielectric layer (6, 7) on the gate SiO₂; and
forming a gate electrode (8), wherein the dielectric layer and the gate electrode are both formed using the same resist as a mask.

7. A method of fabricating a photoelectric conversion semiconductor device as claimed in claim 4 or claim 5 and further comprising the steps of:
forming a first conductivity type impurity region (4) having an impurity concentration higher than the substrate on a surface opposite the surface on which the second conductivity type impurity region is formed;
forming a gate SiO₂ (5) on the first conductivity impurity region;
forming a dielectric layer (6, 7) on the gate SiO₂; and
forming a gate electrode (8), wherein the dielectric layer is formed using the gate electrode as a mask.

8. A method of fabricating a photoelectric conversion semiconductor device in which a second conductivity type impurity region (3) is formed on one surface of a first conductivity type semiconductor substrate (1), a first conductivity type impurity region (4) having an impurity concentration higher than that of the substrate is formed on an opposite surface, and a gate SiO₂ (5), a dielectric layer (6, 7) and a gate electrode (8) are sequentially formed on both impurity regions, characterised by also comprising the steps of:
a resist removal step by means of a solvent, and
a resist removal step by means of oxygen plasma.

9. A method of fabricating a photoelectric conversion semiconductor device comprising the steps of:
forming a second conductivity type impurity region (3) on one surface of a first conductivity type semiconductor substrate (1);
forming a gate SiO₂ (5) on the second conductivity type impurity region;
forming a dielectric layer (6, 7) on the gate SiO₂;
forming a gate electrode (8) on the dielectric layer; and
forming a reverse voltage applying electrode (13) in the second conductivity type impurity region, and a resistor element (9) is formed connected to the reverse voltage applying electrode, characterised in that the gate electrode and resistor element are formed from the same polysilicon film.

10. A photoelectric conversion semiconductor device comprising:
a second conductivity type impurity region (3) on one surface of a first conductivity type semiconductor substrate (1);
a first conductivity type impurity region (4) having an impurity concentration higher than the substrate formed on an opposite surface to the surface on which the second conductivity type impurity region is formed;
a first gate SiO₂ (5) on the second conductivity type impurity region;
a second gate SiO₂ (5) on the first conductivity type impurity region;
a first dielectric layer (6, 7) on the first gate SiO₂;
a second dielectric layer (6, 7) on the second gate SiO₂;
a first gate electrode (8) of poly-crystalline silicon on the first dielectric layer;
a second gate electrode (8) of poly-crystalline silicon on the second dielectric layer;
a first metal electrode (11) on the second conductivity type impurity region;
a second metal electrode (11) on the first conductivity type impurity region;
a polyimide inter-layer insulation film (10) on the first metal electrode; and
a third metal electrode (12) on the polyimide inter-layer insulation film.

11. A photoelectric conversion semiconductor device comprising:
a second conductivity type impurity region (3) on one surface of a first conductivity type semiconductor substrate (1);
a first conductivity type impurity region (4) having an impurity concentration higher than the substrate formed on an opposite surface thereof;
a first gate SiO₂ (5) on the second conductivity type impurity region;
a second gate SiO₂ (5) on the first conductivity type impurity region;
a first dielectric layer (6, 7) on the first gate SiO₂;
a second dielectric layer (6, 7) on the second gate SiO₂;
a first gate electrode (8) of poly-crystalline silicon on the first dielectric layer;
a second gate electrode (8) of poly-crystalline silicon on the second dielectric layer;
a first metal electrode (11) on the second conductivity type impurity region;
a second metal electrode (11) on the first conductivity type impurity region;
a polyimide inter-layer insulation film (10) on the first metal electrode; and
a third metal electrode (12) on the polyimide inter-layer insulation film.
